(19) **Europäisches Patentamt**

**European Patent Office**

**Office européen des brevets**

(11) **EP 1 617 475 A1**

(12) **EUROPEAN PATENT APPLICATION**
published in accordance with Art. 158(3) EPC

(43) Date of publication:
**18.01.2006 Bulletin 2006/03**

(51) Int Cl.:
*H01L 27/04* (1974.07)    *H01L 21/3205* (1990.01)
*H01Q 1/38* (1968.09)    *H01Q 1/40* (1968.09)

(21) Application number: **04724181.5**

(22) Date of filing: **29.03.2004**

(86) International application number:
**PCT/JP2004/004419**

(87) International publication number:
**WO 2004/095576 (04.11.2004 Gazette 2004/45)**

(84) Designated Contracting States:
**AT BE BG CH CY CZ DE DK EE ES FI FR GB GR HU IE IT LI LU MC NL PL PT RO SE SI SK TR**
Designated Extension States:
**AL LT LV MK**

(30) Priority: **23.04.2003 JP 2003117826**

(71) Applicant: **Japan Science and Technology Corporation Kawaguchi-shi, Saitama 332-0012 (JP)**

(72) Inventors:
• **KIKKAWA, Takamaro**
  **Higashihiroshima-shi, Hiroshima 739-0046 (JP)**
• **IWATA, Atsushi**
  **Higashi-hiroshima-shi, Hiroshima 739-004 (JP)**
• **SUNAMI, Hideo**
  **Higashi-hiroshima-shi, Hiroshima 739-004 (JP)**

• **MATTAUSCH, Hans Jurgen**
  **Higashihiroshima-shi, Hiroshima 739-0034 (JP)**
• **YOKOYAMA, Shin**
  **Higashihiroshima-shi, Hiroshima 739-2115 (JP)**
• **SHIBAHARA, Kentaro**
  **Higashihiroshima-shi, Hiroshima 739-0025 (JP)**
• **NAKAJIMA, Anri**
  **Higashihiroshima-shi, Hiroshima 739-0021 (JP)**
• **KOIDE, Tetsushi**
  **Higashihiroshima-shi, Hiroshima 739-0024 (JP)**
• **A.B.M, Harun-ur Rashid**
  **c/o Dpt of El. and El. Eng**
  **Dhaka 1000 (BD)**
• **WATANABE, Shinji**
  **Room 1035**
  **Saiwai-cho,Takatsuki-shi, Osaka 569-1143 (JP)**

(74) Representative: **Hoarton, Lloyd Douglas Charles Forrester & Boehmert, Pettenkoferstrasse 20-22 80336 München (DE)**

(54) **SEMICONDUCTOR DEVICE**

(57)    The present invention provides a semiconductor device in which, in order to prevent wiring delay, an electromagnetic wave is radiated from a transmitting dipole antenna placed on a semiconductor chip and received with a receiving antenna placed in a circuit block included in another semiconductor chip, instead of long metal wires or via-hole interconnection. In the semiconductor device, wireless interconnection is accomplished in such a manner that the electromagnetic wave radiated from the transmitting antenna (3) placed on the semiconductor substrate (1) is transmitted to the receiving antenna (4) placed on the semiconductor substrate (1) or receiving antennas placed on semiconductor substrates; the semiconductor substrates have broadband transmitting/receiving antennas; a signal is transmitted from one or more of the semiconductor substrates and received with the receiving antenna or antennas placed on the semiconductor substrate (1) or substrates, respectively; and the signal transmitted and received has an ultra-wide band communication function.

FIG. 1

**Description**

Technical Field

The present invention relates to semiconductor devices and particularly relates to a configuration of an integrated antenna for reconfigurable wireless interconnection (wireless interconnection using ultra-wideband communication) for transmitting signals between a plurality of semiconductor substrates at ultra-high speed.

Background Art

In known metal interconnection, an aluminum thin-film formed on a semiconductor substrate is processed into microwires, which are directly connected to transistors.

Non-patent Documents 1 to 3 cited below disclose wireless interconnection techniques according to the present invention.

[Non-patent Document 1]

A. B. M. H. Rashid, S. Watanabe, T. Kikkawa, X. Guo, and K.O, "Interference suppression of wireless interconnection in Si integrated antenna", Proc. International Interconnect Technology Conference (IEEE, San Francisco, USA, June 3-5, 2002), pp. 173-175.

[Non-patent Document 2]

A. B. M. H. Rashid, S. Watanabe, and T. Kikkawa, "Wireless Interconnection on Si using Integrated Antenna", Proceedings of 2002 International Conference on Solid State Devices and Materials (Nagoya, Japan, September, 2002), pp. 648-649.

[Non-patent Document 3]

S. Watanabe, A. B. M. H. Rashid, and T. Kikkawa, "Influence of Si Substrate Ground on Antenna Transmission Gain for on-chip Wireless Interconnects", Proc. Conference on Advanced Metallization for ULSI Application, 2002, pp. 94-95.

Disclosure of Invention

In known interconnection techniques using metal wires, an increase in integration increases wiring length and this leads to an increase in the parasitic capacitance and resistance of wires and also leads to an increase in the time constant, which is the product of the parasitic capacitance and resistance thereof; hence, signals transmitted through the wires are delayed.

An increase in system size leads to a decrease in device size. This requires three-dimensional integration. Metal wire interconnections for three-dimensional integration are difficult to fabricate and are not in practical use because alignment with a silicon wafer and deep interconnection with via-holes are necessary.

In view of the foregoing circumstances, it is an object of the present invention to provide a semiconductor device in which, in order to prevent wiring delay, an electromagnetic wave is radiated from a transmitting dipole antenna placed on a semiconductor chip and received with a receiving antenna placed in a circuit block included in another semiconductor chip instead of long metal wires or via-hole interconnection.

[1] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates have broadband transmitting/receiving antennas respectively, a signal is transmitted from one or more of the semiconductor substrates and received with the receiving antenna of the semiconductor substrate or the receiving antennas of the semiconductor substrates, and the signal transmitted and received has an ultra-wideband communication function.

[2] A semiconductor device is characterized in that multilayer wires are arranged in a first interlayer insulating layer placed on a semiconductor substrate, the multilayer wiring metal layer has a transmitting antenna, the transmitting antenna is connected to internal metal wires with via-holes filled with metal, the wiring metal layer having the transmitting antenna is placed in a second interlayer insulating layer, top and bottom of the wiring metal layer being covered thereby, the second interlayer insulating layer has a dielectric constant different from that of the first interlayer insulating layer adjacent thereto so as to satisfy conditions for totally reflecting an electromagnetic wave from the interface between the first and second interlayer insulating layers, and reflectors are arranged on a plane on which the antenna is placed in the direction opposite to a radiation direction.

[3] A semiconductor device is characterized in that multilayer wires are arranged in a first interlayer insulating layer placed on a semiconductor substrate, the multilayer wiring metal layer has a transmitting antenna, the transmitting antenna is connected to internal metal wires with via-holes filled with metal, the wiring metal layer having the transmitting antenna is placed in a second interlayer insulating layer, top and bottom of the wiring metal layer being covered thereby, the second interlayer insulating layer has a dielectric constant different from that of the first interlayer insulating layer adjacent thereto, reflectors are arranged on a plane on which the antenna is placed in the direction opposite to a radiation direction, and the following equations determine the relationship between the distance from the antenna to the internal metal wires and the thickness of the second interlayer insulating layer when an electromagnetic wave is not totally reflected from the interface between the first and second interlayer insulating layers:

$$\text{total reflection angle} = \sin^{-1}\sqrt{} \; (\text{dielectric constant of first interlayer insulating layer} \; / \; \text{dielectric constant of second interlayer insulating layer}) \qquad (1)$$

$$\text{total reflection angle} = \tan^{-1}\sqrt{} \; (\text{distance from antenna to wire} \; / \; \text{thickness of second interlayer insulating layer}) \quad (2).$$

[4] A semiconductor device is characterized in that multilayer wires are arranged in a plurality of interlayer insulating layers arranged on a semiconductor substrate, the multilayer wiring metal layer has a transmitting antenna, the transmitting antenna is connected to internal metal wires with via-holes filled with metal, the wiring metal layer having the transmitting antenna is placed in a first interlayer insulating layer, top and bottom of the wiring metal layer being covered thereby, and the first interlayer insulating layer has a plurality of micro-pores that extend therethrough in the thickness direction thereof to form a photonic band gap at the frequency of an electromagnetic wave transmitted from the antenna.

[5] A semiconductor device is characterized in that multilayer wires are arranged in a plurality of interlayer insulating layers arranged on a semiconductor substrate, the multilayer wiring metal layer has a transmitting antenna, the transmitting antenna is connected to internal metal wires with via-holes filled with metal, the wiring metal layer having the transmitting antenna is placed in a first interlayer insulating layer, top and bottom of the wiring metal layer being covered thereby, the first interlayer insulating layer has a plurality of micro-pores arranged in the thickness direction thereof, and the micro-pores are filled with second interlayer insulating layers having different dielectric constants so as to form a photonic band gap at the frequency of an electromagnetic wave transmitted from the antenna.

[6] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, a multilayer wiring metal layer placed on the semiconductor substrate has a transmitting/receiving antenna, and the antennas are spaced from a ground metal substrate and internal metal wires such that the distance therebetween is greater than the far field distance determined depending on the wavelength of an electromagnetic wave propagated in a semiconductor:

$$\text{distance} = \text{wavelength of wave propagated in Si substrate} \; / \; 2\pi.$$

[7] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, and a low-dielectric constant insulating layer is placed between the semiconductor substrate and a ground metal substrate such that the distance between the antennas and the ground metal substrate and the distance between the antennas and internal metal wires are greater than the far field distance determined depending on the wavelength of an electromagnetic wave propagated in a semiconductor:

```
distance = wavelength of wave propagated in Si

substrate / 2π.
```

[8] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished; a plurality of metal wiring layers are arranged perpendicularly to the radiation direction of the transmitting antenna, connected to each other with via-holes, and divided so as to have a length less than one eighth of the wavelength of an electromagnetic wave propagated in a semiconductor; and a power supply, a ground wire, and a common wire are arranged in parallel to the radiation direction of the transmitting antenna.

[9] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates are arranged so as to achieve multilayer integration, ground metal layers are each placed on the rear face of the semiconductor substrate and the rear face of the outermost semiconductor substrate located most far from the semiconductor substrate such that the ground metal layers cover the rear faces of the semiconductors and face outward, other semiconductor substrates have no ground metal layers, and ground contact is achieved with a substrate surface.

[10] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, ground metal layers having a strip shape are arranged on the rear face of the semiconductor substrate and have a width less than one fourth of the wavelength of an electromagnetic wave propagated in a semiconductor, and the interval between the ground metal layers is greater than one fourth of the wavelength of such an electromagnetic wave propagated in a semiconductor.

[11] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, a lens-shaped insulating layer which is made of a material for forming a first or second interlayer insulating layer and which has a parabolic surface is placed above the transmitting antenna, the first and second interlayer insulating layers have different dielectric constants, and a metal layer is placed on the lens-shaped insulating layer.

[12] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, and timing is adjusted using delay times of a clock-receiving circuit when a synchronous clock signal radiated from the transmitting antenna is received with the receiving antennas, the delay times being obtained by dividing the distances from the transmitting antenna to each of the receiving antennas by the electromagnetic wave transmission speed.

[13] A semiconductor device is characterized in that an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates are arranged at equal intervals so as to achieve multilayer integration, a transmitting/receiving antenna placed on the semiconductor substrate is placed on the same side as that on which the transmitting antenna is placed and serves as a relay for a synchronous clock signal radiated from the transmitting antenna, and the maximum time obtained by dividing the distances between the transmitting and receiving antennas by the electromagnetic wave transmission speed is less than one fourth of the clock period.

[14] A semiconductor device is characterized in that an electromagnetic wave transmission signal is transmitted from a transmitting antenna placed on a semiconductor substrate to receiving antennas placed on a plurality of semiconductor substrates such that wireless interconnection is accomplished, the semiconductor substrates are arranged at equal intervals so as to achieve multilayer integration, and the transmitting and receiving antennas placed on the semiconductor substrates serve as broadband antennas that have a band with a transmission gain of -10 dB being greater than or equal to 25% of the center frequency.

According to the present invention, in a system, dipole antennas and ultra-wideband transmitting/receiving circuits are arranged on a plurality of Si substrates and communication is conducted through the Si substrates. The frequency of an electromagnetic wave propagated in the Si substrates is 20 GHz.

Brief Description of the Drawings

Fig. 1 is a schematic view of a semiconductor device according to a first embodiment of the present invention.
Fig. 2 includes a sectional view showing a configuration of an integrated antenna included in the semiconductor device according to the first embodiment of the present invention and a sectional view of the semiconductor device.
Fig. 3 is an illustration showing a transmitter circuit for ultra-wideband (UWB) communication according to the present invention.
Fig. 4 is an illustration showing a receiver circuit for ultra-wideband (UWB) communication according to the present invention.
Fig. 5 is a sectional view of a semiconductor device according to a second embodiment of the present invention.
Fig. 6 includes sectional views (first) showing steps of manufacturing a semiconductor device according to an embodiment of the present invention.
Fig. 7 includes sectional views (second) showing steps of manufacturing a semiconductor device according to an embodiment of the present invention.
Fig. 8 includes a graph showing the transmission gain of antennas included in Si substrates having different thicknesses, according to a third embodiment of the present invention and also includes schematic sectional views of semiconductor devices.
Fig. 9 is an illustration showing the relationship between the antenna gain and the reflectance at the interface between interlayer insulating layers, included in semiconductor devices including antennas and metal wires arranged near the antennas, having different dielectric constants.
Fig. 10 is a graph showing the relationship between the antenna gain and the length of metal wires arranged near antennas according to a fourth embodiment of the present invention.
Fig. 11 is an illustration showing a wiring pattern in which metal wires according to an embodiment of the present invention are arranged vertically or horizontally in an alternative manner.
Fig. 12 is an illustration showing the dependence of the antenna gain on the frequency, the antenna gain being determined using a wiring pattern, according to an embodiment of the present invention, including metal wires divided into a length equal to one eighth of the wavelength of an electromagnetic wave and in which the metal wires are arranged vertically or horizontally in an alternative manner.
Fig. 13 is an illustration showing arrangements of antennas for transmission between semiconductor substrates according to a fifth embodiment of the present invention.
Fig. 14 is plan view of a semiconductor device according to a sixth embodiment of the present invention.
Fig. 15 is a schematic view showing the transmission between semiconductor devices according to a seventh embodiment of the present invention.
Fig. 16 is a graph showing the relationship between the frequency and the antenna gain determined using the semiconductor devices shown in Fig. 15.

Best Mode for Carrying Out the Invention

Embodiments of the present invention will now be described in detail.
A first embodiment (corresponding to Claim 1) of the present invention will now be described.

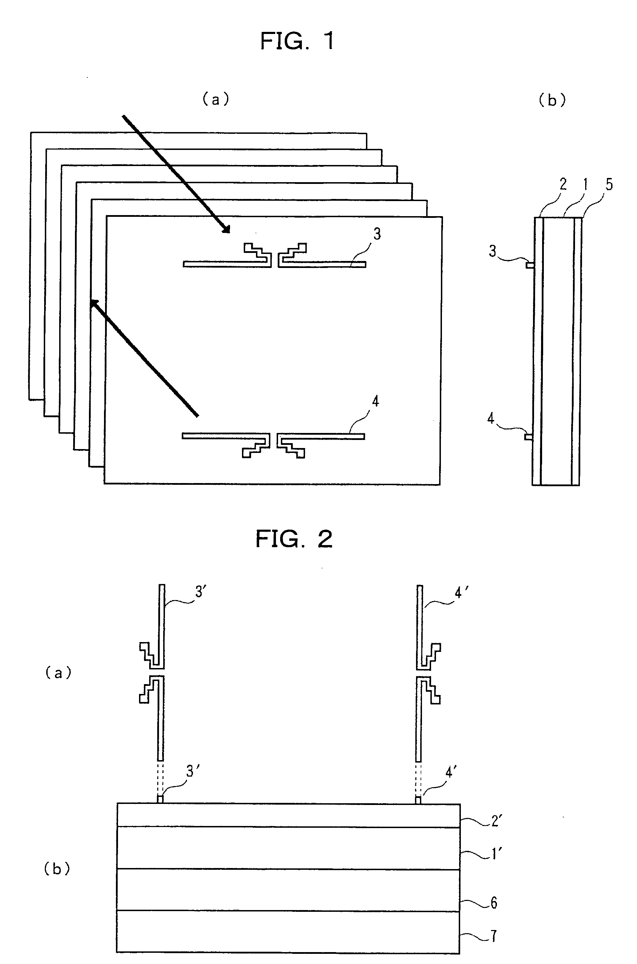

Fig. 1 schematically shows a semiconductor device according to the first embodiment of the present invention. Fig. 1(a) is a plan view thereof and Fig. 1(b) is a sectional view thereof. Fig. 2 shows the semiconductor device and a configuration of an integrated antenna included in the semiconductor device. Fig. 2(a) is a sectional view showing the configuration of the integrated antenna and Fig. 2(b) is a sectional view of the semiconductor device.
As shown in Fig. 1, a silicon dioxide layer ($SiO_2$ layer) 2 with a thickness of 0.5 $\mu$m is formed on a p-type (100) Si substrate 1 with a resistivity of 10 $\Omega$·cm (an average value) in such a manner that the Si substrate 1 is heat-treated at 1000°C for about 120 minutes in an electric furnace in which a gas mixture of hydrogen and oxygen flows. An aluminum layer with a thickness of 1 $\mu$m is deposited on an opposed wafer (not shown) by a DC magnetron sputtering process in such a manner that an aluminum target is bombarded with argon ions.

Dipole aluminum antenna patterns 3 and 4 with a width of 10 $\mu$m are formed on the silicon dioxide layer 2 by a semiconductor lithography process, for example, a plasma etching process, using a photoresist mask and chlorine gas. A ground metal layer 5 is formed under the Si substrate 1, whereby the integrated antenna shown in Fig. 1(a) is obtained.

With reference to Fig. 2, the substrate and layers are arranged in the following order: a SiO$_2$ layer 2' having a thickness of 0.5 $\mu$m, a Si substrate 1' having a resistivity of 8 to 12 $\Omega \cdot$cm and a thickness of 260 $\mu$m, a low-dielectric material (low-k) layer 6 having a thickness of 2.6 mm, and a ground metal layer 7. Dipole aluminum antenna patterns 3' and 4' are arranged on the SiO$_2$ layer 2'.

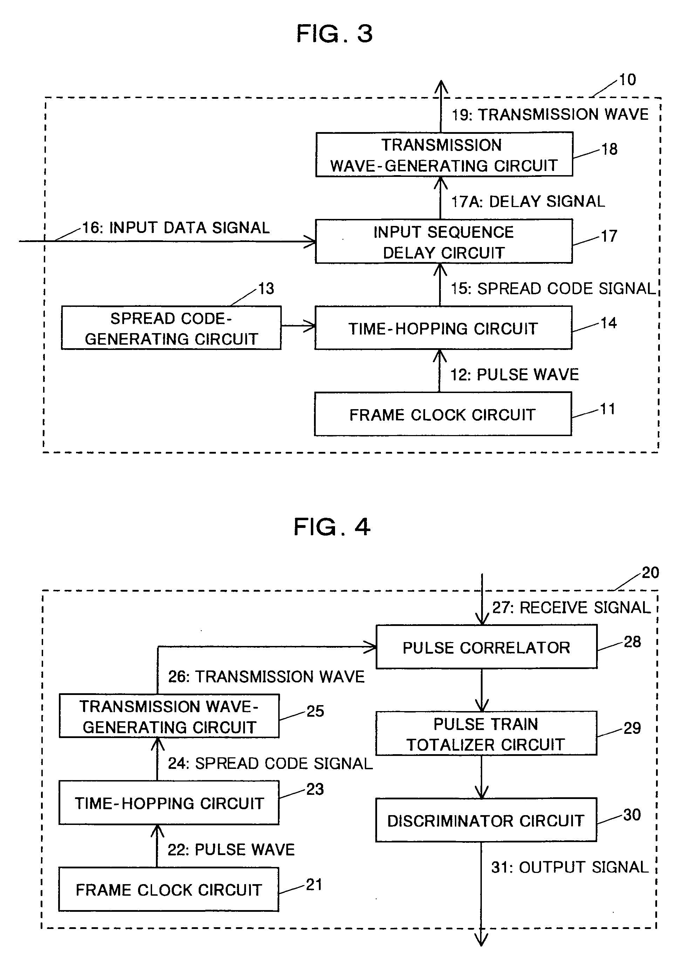

Fig. 3 is an illustration showing a transmitter circuit for ultra-wideband (UWB) communication according to the present invention. Fig. 4 is an illustration showing a receiver circuit for ultra-wideband (UWB) communication according to the present invention. These circuits are described below with reference to a report published in Nikkei Electronics on August 26, 2002, p. 137.

With reference to Fig. 3, the transmitter circuit 10 includes a frame clock circuit 11 for regularly generating a pulse wave 12, a time-hopping circuit 14 for receiving the pulse wave 12 and a signal output from a spread code-generating circuit 13 to output a spread code signal 15, an input sequence delay circuit 17 for receiving the spread code signal 15 and an input data signal 16 to output a delay signal 17A, and a transmission wave-generating circuit 18 for receiving the delay signal 17A to output a transmission wave 19.

With reference to Fig. 4, the receiver circuit 20 includes a frame clock circuit 21 for regularly generating a pulse wave 22, a time-hopping circuit 23 for receiving the pulse wave 22 to generate a spread code signal 24, a transmission wave-generating circuit 25 for receiving the spread code signal 24 to output a transmission wave 26, a pulse correlator 28 for receiving the transmission wave 26 and a receive signal 27, a pulse train totalizer circuit 29 for receiving a signal output from the pulse correlator 28, and a discriminator circuit 30 for receiving a signal output from the pulse train totalizer circuit 29 to output an output signal 31.

UWB is defined as any radio system that utilizes a bandwidth not less than 25 percent of its center frequency. In order to transmit information, no carrier waves are used but short pulses referred to as Gaussian pulses are used. The short pulses have a width of 1 ns or less, for example, a width of several ten to several hundred picoseconds, and an interval of several nanoseconds. Therefore, pulse waves in a very wide frequency band up to several GHz can be used. Signals with such a small pulse width are generated over a short period and then sent from an antenna in the form of baseband signals.

The Shannon limit, which is the maximum rate of transmitting and receiving error-free data, can be expressed as follows:

$$C = Blog(1 + P / N)$$

wherein C represents the maximum capacity (bit/second) of a communication channel, B represents the bandwidth (Hz), P represents the average signal power (W), and N represents the average noise power (W). That is, the maximum capacity of the communication channel is proportional to the bandwidth.

The transmitter circuit 10, which does not require any known carrier wave, includes no VCO (voltage control oscillator), frequency synthesizer, mixer, or intermediate frequency filter as shown in Fig. 3. The frame clock circuit 11 for regularly generating the pulse waves 12 captures delays due to spread codes to generate pulse trains separated in time at random to create a time-hopping pattern.

The receiver circuit 20 shown in Fig. 4 correlates with a template waveform and identifies a pulse signal.

In the present invention, ultra-wideband transmission circuits and wideband transmission antennas are integrated on a silicon substrate using the techniques described above. An electromagnetic wave signal is transmitted from the silicon substrate and received with receiver antennas integrated on a plurality of other silicon substrates, whereby a pulse signal is identified.

A second embodiment (corresponding to Claim 2 or 3) of the present invention will now be described.

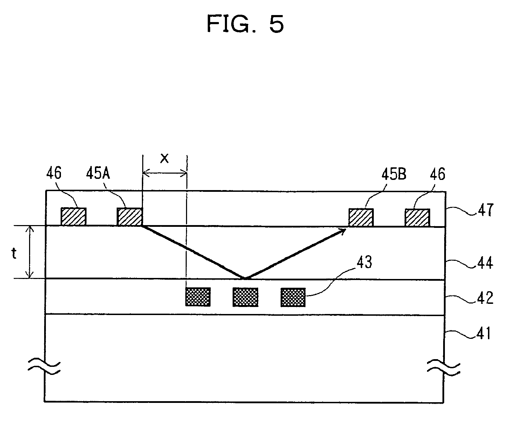

Fig. 5 is a sectional view of a semiconductor device according to the second embodiment of the present invention.

In this figure, reference numeral 41 represents a Si substrate, reference numeral 42 represents a first insulating layer (a low dielectric constant and a relative dielectric constant of 2.0) surrounding metal wiring layers including multilayer wires, reference numeral 43 represents the metal wiring layers, reference numeral 44 represents a second insulating layer (a high dielectric constant and a relative dielectric constant of 7.0) placed under antennas 45 (a transmitting antenna 45A and a receiving antenna 45B), reference numeral 45A represents the transmitting antenna, reference numeral 45B represents the receiving antenna, reference numeral 46 represents reflectors, and reference numeral 47 represents an antenna layer.

In this embodiment, in order to reduce the interference between the antennas 45 (the transmitting antenna 45A and the receiving antenna 45B) and the metal wiring layers 43, the antenna layer 47 is spaced from the metal wiring layers 43. The standard of the spacing is as described below.

In order to prevent electromagnetic waves transmitted from the transmitting antenna 45A from interfering with metal wiring layers 43, it is necessary to find conditions for totally reflecting the electromagnetic waves from the interface of the first insulating layer 42 surrounding the metal wiring layer 43. Furthermore, it is necessary that the metal wiring layers 43 are not arranged in regions that do not satisfy total reflection conditions.

Therefore, the metal wiring layers 43 which include the multilayer wires made of copper are arranged in the low-dielectric constant interlayer insulating layer 42 having a relative dielectric constant of 2.0, which is placed on the Si substrate 41, and the antennas 45 are insulated with the high-dielectric constant interlayer insulating layer 44 having a dielectric constant of 7.0. The transmitting antenna 45A is placed in a portion of the antenna layer 47 and the metal wiring layers 43 are arranged in the low-dielectric constant porous silica (first insulating layer) 42 having a dielectric constant of 2.0 in such a manner that top and bottom of the metal wiring layer are covered thereby.

The second insulating layer 44 is made of silicon nitride, formed by a plasma-enhanced CVD (chemical vapor deposition) process, and has a dielectric constant greater than that of the first insulating layer 42 adjacent thereto. A region that satisfies conditions for totally reflecting the electromagnetic waves from the interface between the first insulating layer 42 and the second insulating layer 44 is determined by below equations that describe the relationship between the distance x from the antennas 45 to the metal wiring layers 43 and the thickness t of the second insulating layer 44. The reflectors 46 are arranged on the same plane of the antenna layer 47 in the direction opposite to the transmission direction.

$$\text{Total Reflection Angle} = \sin^{-1}\sqrt{} \text{ (Dielectric Constant of First Insulating Layer / Dielectric Constant of Second Insulating Layer)} \qquad (1)$$

$$\text{Total Reflection Angle} = \tan^{-1}\sqrt{} \text{ (Distance from Antennas to Wires / Thickness of Second Insulating Layer)} \qquad (2)$$

This configuration is effective in improving the antenna gain of the semiconductor device.

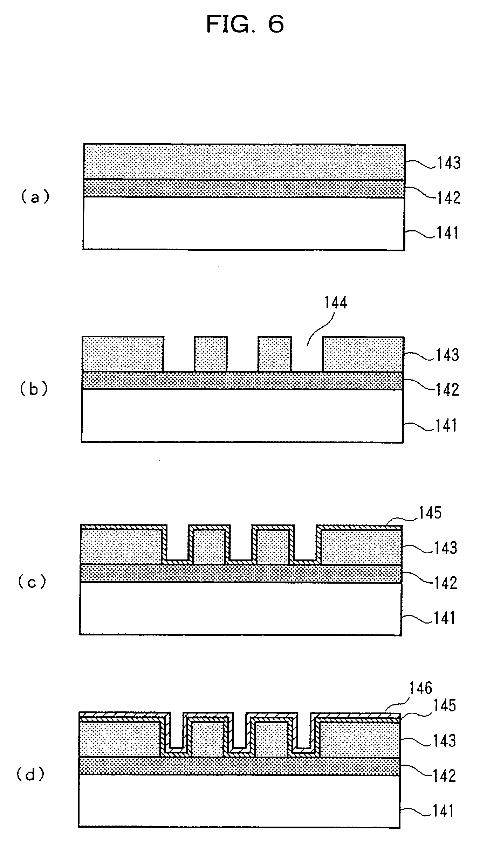

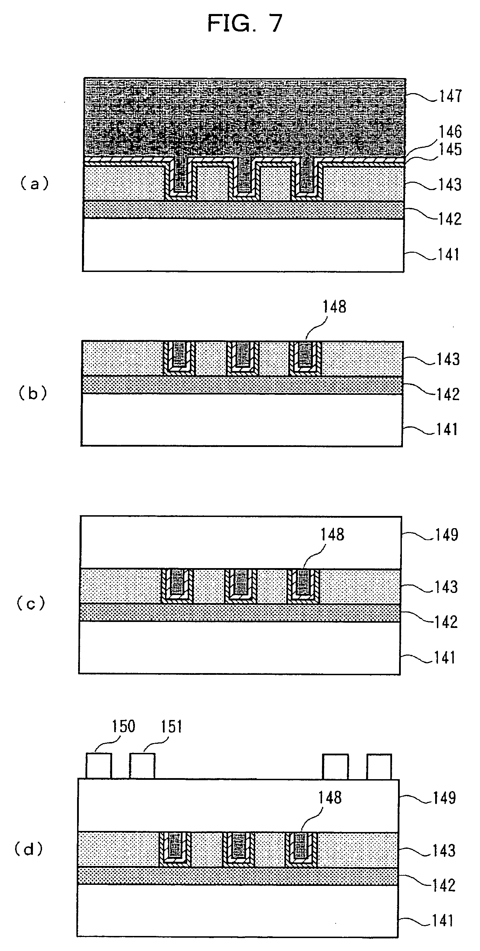

The configuration with which the antenna gain of the semiconductor improve and manufacturing steps thereof will now be described with reference to Figs. 6 and 7.

As shown in Fig. 6(a), a silicon dioxide layer (not shown) with a thickness of 0.5 $\mu$m is formed on a p-type (100) Si substrate 141 having a resistivity of 10 $\Omega\cdot$cm and a silicon nitride layer 142 having a thickness of 0.2 $\mu$m is then formed thereon by a plasma-enhanced chemical vapor deposition process in such a manner that silicon tetrahydride, silane, and ammonia $NH_3$ are allowed to react with each other at 400°C. The silicon nitride layer 142 serves as a dry etching stopper. A low-dielectric constant interlayer insulating layer 143 which is a first insulating layer and which has a relative dielectric constant of 2.0 is formed thereon. In this operation, the first insulating layer 143, made of porous silica, having a thickness of 500 nm is formed by the following procedure: an SOG (Spin-on-Glass) is prepared by dissolving TEOS (tetraethyl orthosilicate) in an ethanol solvent, a solution is prepared by mixing the SOG with ATMA (alkyltrimethylammonium) which is a cationic surfactant and which serves as a porous agent, the silicon nitride layer 142 is spin-coated with a mixture of the SOG and the solution at 3000 rpm, and the coating is baked at 180°C for one hour and then 400°C for one hour.

The low-dielectric constant interlayer insulating layer 143 with a thickness of 0.5 $\mu$m may be formed by the following procedure: the silicon nitride layer 142 is spin-coated with, for example, a porous methylsilsesquioxane precursor with a relative dielectric constant of 2.0 at 3000 rpm and the coating is baked at 150°C for three minutes, 250°C for five minutes, and then 400°C for 30 minutes in air.

A silicon dioxide layer which serves as a hard mask (not shown) for dry etching and which has a thickness of 0.2 $\mu$m is formed by a plasma-enhanced chemical vapor deposition process in such a manner that silicon tetrahydride, silane, and nitrous oxide $N_2O$ are allowed to react with each other at 400°C. As shown in Fig. 6(b), a wiring groove pattern is formed in the silicon dioxide layer by a photolithographic process using plasma. The first insulating layer 143 is plasma-etched with a fluorocarbon gas using the resulting silicon dioxide layer as a mask, whereby grooves 144 are formed.

After a photoresist layer (not shown) is removed, as shown in Fig. 6(c), a tantalum thin-film 145 which has a thickness of 0.1 $\mu$m and which serves as a barrier metal layer is formed on an opposed wafer by a DC magnetron sputtering process in such a manner that a tantalum target is bombarded with argon ions in plasma.

As shown in Fig. 6(d), a copper thin-film 146 which has a thickness of 0.2 $\mu$m and which serves as a seed layer for copper plating is formed on the opposed wafer by a DC magnetron sputtering process in such a manner that a copper target is bombarded with argon ions in plasma.

As shown in Fig. 7(a), a copper coating 147 with a thickness of 1 $\mu$m is formed on the wafer in such a manner that the wafer is plated with copper using copper sulfate and a dilute sulfuric acid solution.

As shown in Fig. 7(b), the copper coating 147 is planarized by chemical mechanical polishing, whereby wiring patterns (metal wiring layers) 148 are formed such that the wiring patterns 148 remain in the grooves 144.

The metal wiring layers 148 are connected to each other by repeating the steps shown in Figs. 6(a) to 6(d), 7(a), and 7(b). A silicon nitride layer 142' (not shown) which serves as a cap layer and which has a thickness of 0.2 $\mu$m is formed by a plasma-enhanced chemical vapor deposition process in such a manner that silicon tetrahydride, silane, and ammonia $NH_3$ are reacted with each other at 400°C. A low-dielectric constant interlayer insulating layer 143' (not shown) which is a first insulating layer and which has a relative dielectric constant of 2.0 is formed thereon. In this operation, the first insulating layer 143', made of porous silica, having a thickness of 500 nm is formed (not shown) by the following procedure: an SOG (Spin-on-Glass) is prepared by dissolving TEOS (tetraethyl orthosilicate) in an ethanol solvent, a solution is prepared by mixing the SOG with ATMA (alkyltrimethylammonium) which is a cationic surfactant and which serves as a porous agent, the silicon nitride layer 142' is spin-coated with a mixture of the SOG and the solution at 3000 rpm, and the coating is then baked at 180°C for one hour and then 400°C for one hour.

The low-dielectric constant interlayer insulating layer 143' with a thickness of 0.5 $\mu$m may be formed by the following procedure: the silicon nitride layer 142' is spin-coated with, for example, a porous methylsilsesquioxane precursor with a relative dielectric constant of 2.0 at 3000 rpm and the coating is baked at 150°C for three minutes, 250°C for five minutes, and then 400°C for 30 minutes in air.

A photoresist for forming via-holes (not shown) is patterned by a photolithographic process. The first insulating layer 143' (not shown) is plasma-etched with a fluorocarbon gas using the resulting photoresist as a mask, whereby grooves 144' (not shown) are formed. The plasma silicon nitride layer serving as the cap layer is etched, whereby the via-holes extending to lower copper wires are formed. Titanium nitride thin-films which have a thickness of 0.1 $\mu$m and which serve as barrier metal layers are formed in the via-holes in an opposed wafer by a DC magnetron sputtering process in such a manner that a titanium target is bombarded with argon and nitrogen ions in plasma. Tungsten hexafluoride is deposited thereon by a chemical vapor deposition process and then reduced, whereby tungsten plugs are formed. This procedure is repeated, whereby multilayer damascene wires (not shown) are formed. Plugs coated with copper may be used instead of the tungsten plugs.

As shown in Fig. 7(c), a silicon nitride layer 149 which serves as a high-dielectric constant insulating layer and which has a thickness of 1.0 $\mu$m is formed over the pattern-formed metal wiring layers 148 by a plasma-enhanced chemical vapor deposition process in such a manner that silicon tetrahydride, silane, and ammonia $NH_3$ are reacted with each other at 400°C.

As shown in Fig. 7(d), an aluminum thin-film with a thickness of 1 $\mu$m is formed on an opposed wafer by a DC magnetron sputtering process in such a manner that an aluminum target is bombarded with argon ions in plasma. Dipole antenna patterns 150 and 151 having a thickness of 1 $\mu$m and a width of 10 $\mu$m are formed by a dry etching process using chlorine plasma in such a manner that a photoresist layer (not shown) formed by a photolithographic process is used as a mask.

A third embodiment (corresponding to Claim 4) of the present invention will now be described.

As shown in Fig. 1, a silicon dioxide layer 2 with a thickness of 0.5 $\mu$m is formed on a p-type (100) Si substrate 1 having a resistivity of 10 $\Omega$·cm and a thickness of 260 $\mu$m in such a manner that the Si substrate 1 is heat-treated at 1000°C for about 120 minutes in an electric furnace in which a gas mixture of hydrogen and oxygen flows. An aluminum layer with a thickness of 1 $\mu$m is deposited on an opposed wafer by a DC magnetron sputtering process in such a manner that an aluminum target bombarded with argon ions. Dipole aluminum antenna patterns 3 and 4 having a width of 10 $\mu$m and an antenna length of 2 mm are formed by a semiconductor lithography process, for example, a plasma etching process, using a photoresist mask and chlorine-containing gas.

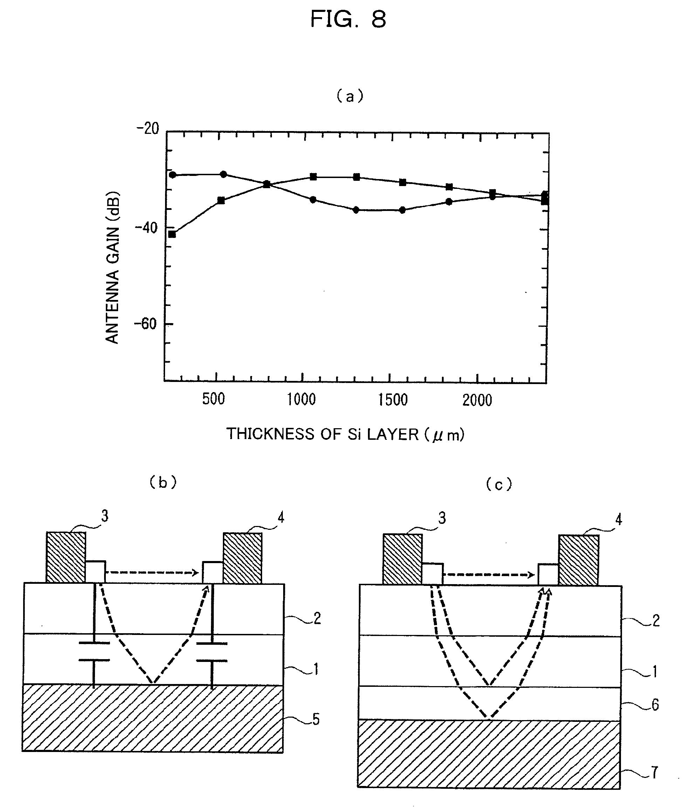

A ground metal layer 5 is formed by rendering the rear face of the wafer conductive so as to make contact with a substrate. Fig. 8 includes a graph showing the dependence of the transmission gain of antennas included in grounded Si substrates 1 on the thickness of the Si substrates and also includes schematic sectional views of semiconductor devices.

In Fig. 8, Fig. 8(a) is a graph showing the transmission gain of antennas arranged above Si substrates which have loss and which have different thicknesses, wherein symbol ■ represents the antenna transmission gain that is determined in such a manner that the Si substrates included in semiconductor devices are directly grounded with metal layers and symbol • represents the antenna transmission gain that is determined in such a manner that the Si substrates included in semiconductor devices are grounded with low-dielectric constant material layers. Fig. 8(b) is a schematic sectional view of a semiconductor device including a Si substrate directly grounded with a metal layer placed thereunder and Fig. 8(c) is a schematic sectional view of a semiconductor device in which a low-dielectric constant material layer is placed between a Si substrate and a metal layer.

In particular, the semiconductor devices (■) including the Si substrates 1 directly grounded with metal layers 5 placed thereunder and the semiconductor devices (•) in which low-dielectric constant material layers 6 are placed between the Si substrates 1 and ground metal layers 7 were measured for antenna transmission gain under the following conditions: an antenna length L of 2.0 mm and a distance d between antennas of 3.0 mm. The thickness h of the Si substrates 1 ranges from 260 to 2340 $\mu$m in increments of 260 $\mu$m.

For the semiconductor devices (■) including the Si substrates 1 directly grounded with the metal layers 5 as shown in Fig. 8(b), a reduction in the thickness of the Si substrates 1 reduces the antenna gain. When the thickness of the Si substrates 1 exceeds a certain value, the antenna gain is approximately saturated.

In contrast, for the semiconductor devices (•) in which the low-dielectric constant material layers 6 are placed between the Si substrates 1 and the ground metal layers 7 as shown in Fig. 8(c), an increase in the thickness of the Si substrates 1 reduces the antenna gain. When the thickness of the Si substrates 1 exceeds about 1500 $\mu$m, the antenna gain increases.

This shows that when the Si substrates 1 have a small thickness, the antenna gain can be increased by 10 dB or more in such a manner that the low-dielectric constant material layers 6 are placed between the Si substrates 1, and the ground metal layers 7.

The far-field boundary of the electromagnetic field of an electromagnetic wave radiated from an antenna is given by Inequality (3) below in the form of a function of the wavelength of the electromagnetic wave propagated in a Si substrate and calculation shows that the far-field boundary is 689 $\mu$m.

$$r \geq (\lambda_{Si-20GHz}) / 2\pi \qquad\qquad (3)$$

When the distance r from each antenna shown in Fig. 8(b) to a ground plane is less than 689 $\mu$m, a region between the antenna and the ground plane is a near field. The transmission power of an electromagnetic wave emitted from the transmitting antenna is reduced by the effect of electrostatic capacitive coupling between the transmitting antenna and the ground metal layer placed under the Si substrate; hence, the antenna transmission gain is reduced. This shows that the distance r between the antenna and the ground plane (Metal) needs to satisfy the far-field condition of electromagnetic waves.

When the low-dielectric material layer 6 is placed between the Si substrate 1 and the ground metal layer 7 as shown in Fig. 8(c), the far-field condition of electromagnetic waves is satisfied. However, since the Si substrate 1 is a lossy media, an increase in the thickness of the Si substrate 1 placed in an electromagnetic wave path leads to an increase in loss, resulting in a reduction in antenna transmission gain.

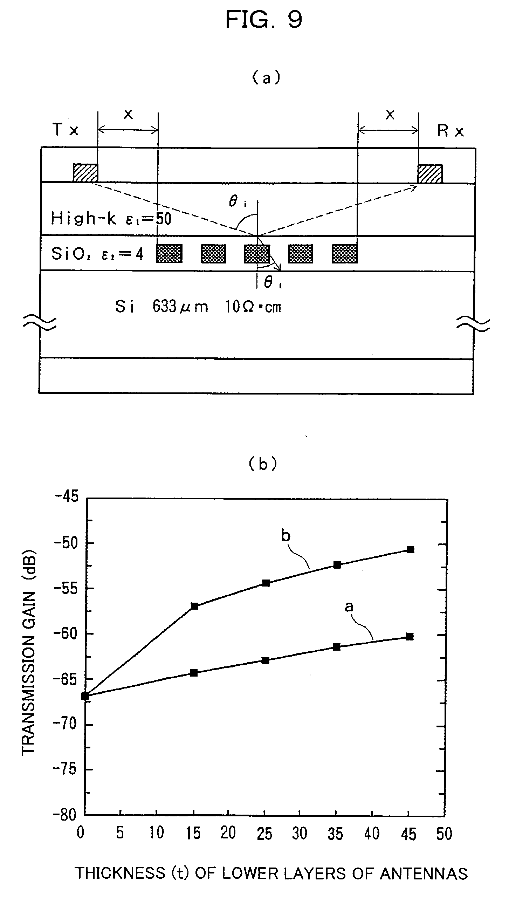

Fig. 9 shows the relationship between the antenna gain and the reflectance at the interface between interlayer insulating layers, included in a semiconductor device including antennas and metal wires arranged near the antennas, having different dielectric constants. Fig. 9(a) is a schematic sectional view of each semiconductor device (Curb b in Fig. 9(b)). Fig. 9(b) is a graph showing the relationship between the transmission gain (dB) and the thickness ($\mu$m) of the interlayer insulating layers placed under the antennas, Curb a shows data determined at a frequency of 20 GHz using the interlayer insulating layers made of oxide, and Curb b shows data determined at a frequency of 20 GHz using the interlayer insulating layers having a high relative dielectric constant ($\varepsilon_r = 50$).

A fourth embodiment (corresponding to Claim 9) of the present invention will now be described.

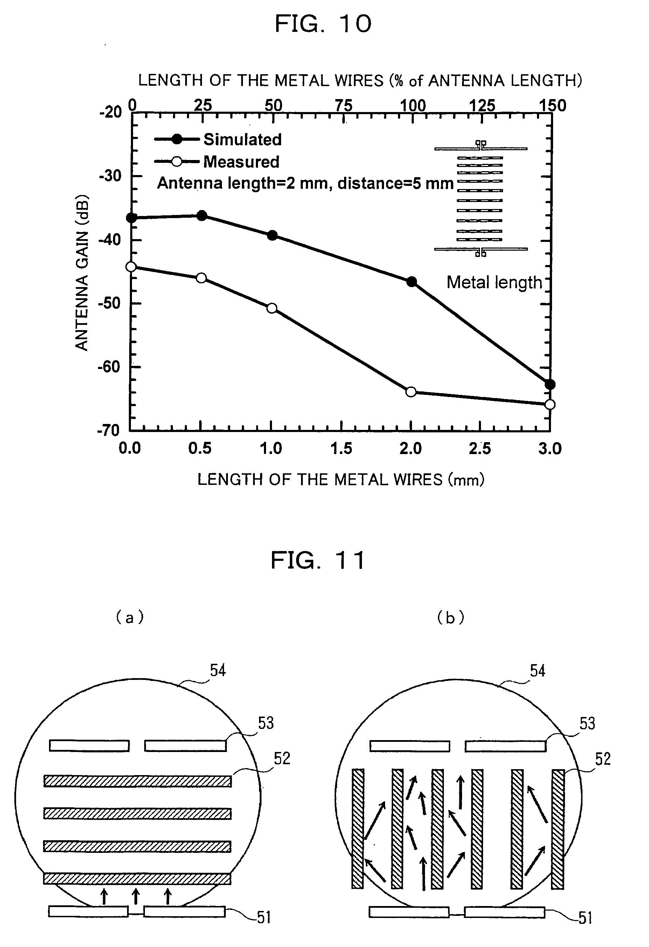

Metal wires arranged near antennas cause interference. Fig. 10 shows the relationship between the antenna gain and the length of such metal wires.

Fig. 10 is a graph showing the relationship between the antenna gain and the length of the metal wires arranged near the antennas according to the fourth embodiment of the present invention. In this graph, the lower horizontal axis represents the length (mm) of the metal wires, the upper horizontal axis represents the percentage (%) of the metal wire length with respect to the length of the antennas, and the vertical axis represents the antenna gain $G_a$ (dB). The metal wires are arranged perpendicularly to the direction in which electromagnetic waves are radiated from the antennas.

As is clear from Fig. 10, when the length of the metal wires arranged perpendicularly to the direction in which electromagnetic waves are radiated from the antennas is greater than 25% of the antenna length, the antenna gain is decreased. That is, when the metal wire length is greater than one eighth of the length of an electromagnetic wave propagated in a Si substrate, reflection and/or interference occurs and this leads to a reduction in antenna gain.

Fig. 11 shows devices including antennas and wires arranged in parallel to or perpendicularly to the antennas. Reference numeral 51 represents transmitting antennas, reference numeral 52 represents metal wires, reference numeral 53 represents receiving antennas, and reference numeral 54 represents the radiation pattern from the transmitting antennas 51.

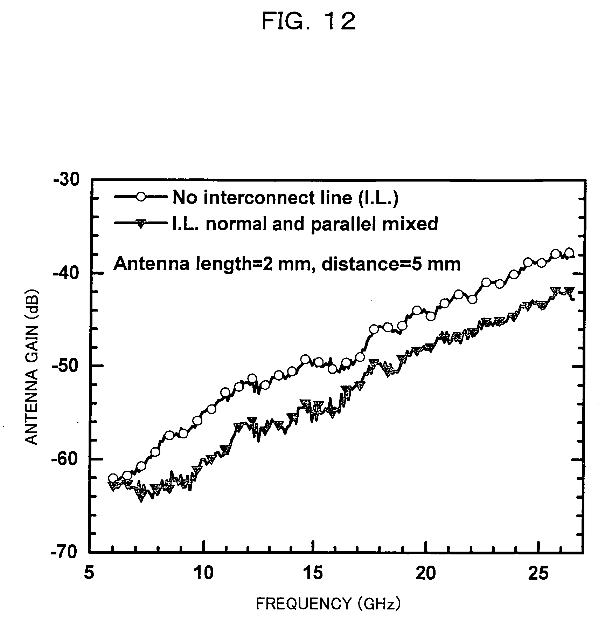

Fig. 12 is schematic view which shows a wiring pattern in which metal wires are arranged vertically or horizontally in an alternative manner and which shows the dependence of the antenna gain on the frequency. The metal wires have a length equal to one eighth of the frequency of an electromagnetic wave. In Fig. 12, the horizontal axis shows the frequency (GHz), the vertical axis shows the antenna gain $G_a$ (dB), symbol O represents data obtained from devices including no metal wires (IL) that cause interference, and symbol ▼ represents data obtained from devices including metal wires (IL).

A fifth embodiment (corresponding to Claim 11) of the present invention will now be described.

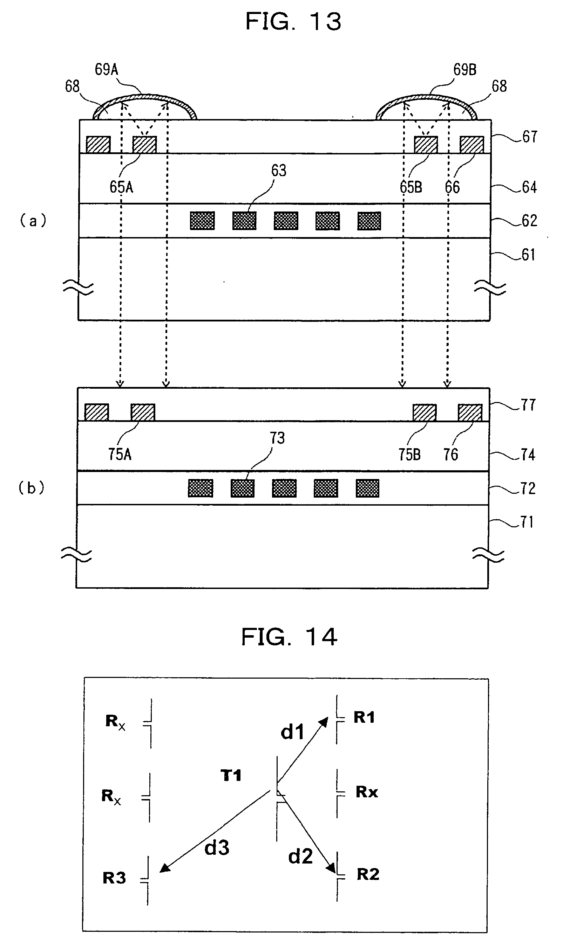

Fig. 13 includes sectional views of semiconductor substrates according to a fifth embodiment of the present invention.

In Fig. 13(a), reference numeral 61 represents a Si substrate; reference numeral 62 represents a first insulating layer (a relative dielectric constant of 4.0); reference numeral 63 represents a metal wire layer; reference numeral 64 represents a second insulating layer (a relative dielectric constant of 2 to 3, for example, 2.7); reference numeral 65 represents antennas (reference numeral 65A represents a transmitting antenna and reference numeral 65B represents a receiving antenna); reference numeral 66 represents reflectors; reference numeral 67 represents an antenna layer; reference numeral 68 represents lens-shaped insulating layers which are arranged above the antennas 65, which are made of the same material as that for forming the first or second insulating layer, and which have a parabolic surface; and reference numerals 69A and 69B represent parabolic mirrors.

In Fig. 13(b), reference numeral 71 represents a Si substrate, reference numeral 72 represents a first insulating layer (a relative dielectric constant of 4.0), reference numeral 73 represents a metal wire layer, reference numeral 74 represents a second insulating layer (a relative dielectric constant of 2 to 3, for example, 2.7), reference numeral 75A represents a transmitting antenna, reference numeral 75B represents a receiving antenna, reference numeral 76 represents reflectors, and reference numeral 77 represents an antenna layer.

In the first embodiment, wireless interconnection is used to transmit an electromagnetic transmission signal from the transmitting antenna 65A to the receiving antenna 65B placed above the Si substrate 61 or receiving antennas 65B placed above a plurality of Si substrates. The lens-shaped insulating layers 68, made of the same material as that for forming the first insulating layer or the second insulating layer having a dielectric constant different from that of the first insulating layer, having such a parabolic surface are arranged above the antennas 65. The lens-shaped insulating layers 68 each have corresponding reflective metal layers 69 placed thereon. The antennas 65A and 65B are each located at the corresponding focal points of the parabolic mirrors 69A and 69B, and are metal layers. The reflectors 66 are arranged on the same plane.

A sixth embodiment (corresponding to Claim 12) of the present invention will now be described.

Fig. 14 is plan view of a semiconductor device according to the sixth embodiment of the present invention.

When an electromagnetic transmission signal, that is, a synchronous clock signal, is transmitted from a transmitting antenna T1 placed on a Si substrate to receiving antennas R1, R2, and R3 placed on the Si substrate, timing is adjusted using delay times t1, t2, and t3 of a clock-receiving circuit, the delay times t1, t2, and t3 being obtained by dividing the distances d1, d2, and d3, that is a distance from the transmitting antenna T1 to each of the receiving antenna R1, R2 and R3 respectively, by the electromagnetic wave transmission speed.

A seventh embodiment (corresponding to Claim 13) of the present invention will now be described.

In this embodiment as well as the sixth embodiment (Fig. 14), a first insulating layer with a relative dielectric constant of 4.0 is formed on a p-type (100) substrate with a resistivity of 10 Ω·cm and a second insulating layer having a relative dielectric constant of 2.7 and a thickness of 0.5 μm is formed thereon in such a manner that the first insulating layer is spin-coated with, for example, a methylsilsesquioxane precursor at 3000 rpm and the coating is baked at 150°C for three minutes, 250°C for five minutes, and then 400°C for 30 minutes in air. An aluminum thin-film is formed by a DC magnetron sputtering process in which an aluminum target is bombarded with argon ions in plasma. Dipole antennas having a thickness of 1 μm and a width of 10 μm are formed by a dry etching process using a mask formed by patterning a photoresist by a photolithographic process. This procedure is repeated, whereby multilayer wires are formed. Wiring layers other than antenna patterns are formed in known wiring patterns.

A plurality of Si substrates having semiconductor integrated circuits thereon are stacked and a transmitting antenna pattern is provided at an end of a Si chip placed on one of the substrates. A synchronous clock signal for a plurality of Si chips is transmitted from the transmitting antenna, the signals being a 20-GHz sine wave. Receiving antennas are each arranged at corresponding ends of other stacked Si substrates and receive the synchronous clock signal, that is, an electromagnetic sine wave, propagated through the Si substrate. The signal phase delay that is the skew of the synchronous clock is adjusted with the circuit of the Si substrate.

When the pitch of the stacked Si substrates is 2 mm, the distance from a transmitting antenna to a receiving antenna of a next substrate is 2 mm. The delay time can be precisely determined by dividing the distance by the phase velocity of an electromagnetic wave. Since the delay time is about 10 psec and is less than one fourth of the period of an original clock signal, the period being equal to 50 psec, the phase delay of a waveform can be adjusted in advance.

A clock signal of which the phase has been forwarded in advance by adjusting the waveform phase delay is transmitted from a transmitting antenna placed at the same end to a next substrate. That is, the phase of a transmitted clock signal is shifted forward to the phase of a received clock signal by the delay time between chips.

The signal is relayed to a receiving antenna of a second substrate and then a receiving antenna of a third substrate in the same manner as described above. This enables the relay of the signal by adjusting the phase delay even if a large number of substrates are stacked, resulting in the solution of a clock skew problem.

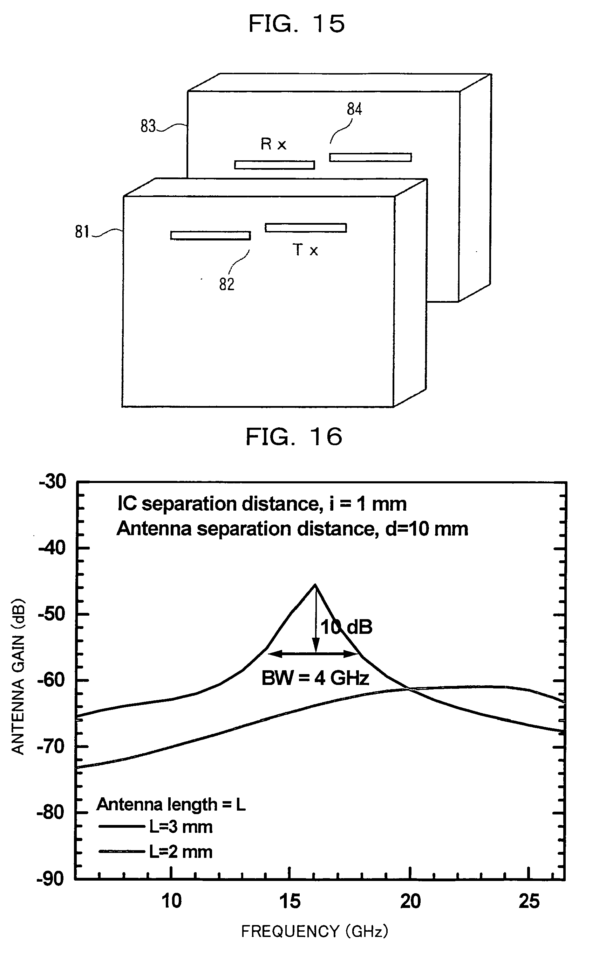

Fig. 15 is a schematic view showing the transmission between semiconductor devices according to the seventh embodiment of the present invention. Fig. 16 is a graph showing the relationship between the frequency and the antenna gain determined using the semiconductor devices shown in Fig. 15.

In Fig. 15, reference numeral 81 represents a first semiconductor device (a first semiconductor integrated circuit device or a first IC), reference numeral 82 represents a transmitting antenna mounted on the first semiconductor device 81, reference numeral 83 represents a second semiconductor device (a second semiconductor integrated circuit device or a second IC), and reference numeral 84 represents a receiving antenna mounted on the second semiconductor device 83. In this embodiment, the spaced semiconductor devices 81 and 83 are interconnected to each other by GHz-band wireless communication without using wires.

Fig. 16 shows the relationship between the frequency and the antenna gain that is determined in such a manner that the first and second semiconductor devices 81 and 83 are spaced at 1 mm and the transmitting antenna 82 and the receiving antenna 84 are spaced at 10 mm. The horizontal axis represents the frequency (GHz) and the vertical axis represents the antenna gain (dB). In Fig. 16, Curve a represents data obtained using antennas with a length of 3 mm and Curve b represents data obtained using antennas with a length of 2mm. Curve a shows that when the antenna length is 3 mm, the antenna gain reaches its maximum at a frequency of about 14 to 18 GHz (a band width of 4 GHz).

The present invention is applicable to any semiconductor device, such as an ultra-LSI or a DRAM, having interconnection with high-speed LSIs.

The present invention is not limited to the above examples and various modifications may be made within the scope of the present invention.

As described above in detail, according to the present invention, advantages below can be achieved.

The present invention provides semiconductor reconfigurable wireless interconnection capable of transmitting signals between a plurality of semiconductor substrates at ultra-high speed. Signals can be transmitted from metal antennas arranged on a plurality of semiconductor substrates to other semiconductor substrate through the semiconductor substrates in a wireless manner.

In particular, the present invention provides the following features:

(1) A plurality of semiconductor chips have antennas for broad band communication.
(2) A transmission signal is propagated in a Si substrate and received with an antenna placed on other semiconductor substrate.
(3) A signal is transmitted or received by ultra-wideband communication (wireless communication (a band used is 2 to 20 GHz) in which the center frequency is about 10 to 20 GHz, in which a frequency band used is greater than or equal to 25% of the center frequency, in which the pulse width of a transmission signal is 1 ns or less, in which any carrier wave is not used, and which is performed at a electromagnetic interference standard (-41.3 dBm/MHz) or less). In embodiments, a frequency of 6 to 25 GHz is used.
(4) A layer including a transmitting/receiving antenna is spaced from a metal wiring layer.
(5) An interlayer insulating layer for spacing a transmitting/receiving antenna from a metal wire has a high dielectric constant.
(6) A metal wire having a length greater than one eighth of the length of an electric wave radiated from a transmitting/receiving antenna is divided.
(7) Metal wires are arranged in the direction perpendicular to a transmitting/receiving antenna.
(8) The distance between a ground metal and a semiconductor substrate having a transmitting/receiving antenna is greater than the far field distance of an electromagnetic wave.

Industrial Applicability

A semiconductor device according to the present invention can be used for a next-generation semiconductor apparatus capable of preventing wiring delay.

**Claims**

**1.** A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates have broadband transmitting/receiving antennas respectively, a signal is transmitted from one or more of the semiconductor substrates and received with the receiving antenna of the semiconductor substrate or the receiving antennas of the semiconductor substrates, and the signal transmitted and received has an ultra-wideband communication function.

2.  A semiconductor device **characterized in that** multilayer wires are arranged in a first interlayer insulating layer placed on a semiconductor substrate, the multilayer wiring metal layer has a transmitting antenna, the transmitting antenna is connected to internal metal wires with via-holes filled with metal, the wiring metal layer having the transmitting antenna is placed in a second interlayer insulating layer, top and bottom of the wiring metal layer being covered thereby, the second interlayer insulating layer has a dielectric constant different from that of the first interlayer insulating layer adjacent thereto so as to satisfy the condition that an electromagnetic wave is totally reflected from the interface between the first and second interlayer insulating layers, and reflectors are arranged on a plane on which the antenna is placed in the direction opposite to a radiation direction.

3.  A semiconductor device **characterized in that** multilayer wires are arranged in a first interlayer insulating layer placed on a semiconductor substrate, the multilayer wiring metal layer has a transmitting antenna, the transmitting antenna is connected to internal metal wires with via-holes filled with metal, the wiring metal layer having the transmitting antenna is placed in a second interlayer insulating layer, top and bottom of the wiring metal layer being covered thereby, the second interlayer insulating layer has a dielectric constant different from that of the first interlayer insulating layer adjacent thereto, reflectors are arranged on a plane on which the antenna is placed in the direction opposite to a radiation direction, and the following equations determine the relationship between the distance from the antenna to the internal metal wires and the thickness of the second interlayer insulating layer when an electromagnetic wave is not totally reflected from the interface between the first and second interlayer insulating layers:

$$\text{total reflection angle} = \sin^{-1}\sqrt{}\ (\text{dielectric constant of first interlayer insulating layer / dielectric constant of second interlayer insulating layer}) \qquad (1)$$

$$\text{total reflection angle} = \tan^{-1}\sqrt{}\ (\text{distance from antenna to wire / thickness of second interlayer insulating layer}) \qquad (2).$$

4.  A semiconductor device **characterized in that** multilayer wires are arranged in a plurality of interlayer insulating layers arranged on a semiconductor substrate, the multilayer wiring metal layer has a transmitting antenna, the transmitting antenna is connected to internal metal wires with via-holes filled with metal, the wiring metal layer having the transmitting antenna is placed in a first interlayer insulating layer, top and bottom of the wiring metal layer being covered thereby, and the first interlayer insulating layer has a plurality of micro-pores that extend therethrough in the thickness direction thereof to form a photonic band gap at the frequency of an electromagnetic wave transmitted from the antenna.

5.  A semiconductor device **characterized in that** multilayer wires are arranged in a plurality of interlayer insulating layers arranged on a semiconductor substrate, the multilayer wiring metal layer has a transmitting antenna, the transmitting antenna is connected to internal metal wires with via-holes filled with metal, the wiring metal layer having the transmitting antenna is placed in a first interlayer insulating layer, top and bottom of the wiring metal layer being covered thereby, the first interlayer insulating layer has a plurality of micro-pores arranged in the thickness direction thereof, and the micro-pores are filled with second interlayer insulating layers having different dielectric constants so as to form a photonic band gap at the frequency of an electromagnetic wave transmitted from the antenna.

6.  A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, a multilayer wiring metal layer placed on the semiconductor substrate has a transmitting/receiving antenna, and the antennas are spaced from a ground metal substrate and internal metal wires such that the distance therebetween is greater than the far field distance determined depending on the wavelength of an electromagnetic wave propagated in a semiconductor:

```
distance = wavelength of wave propagated in Si

substrate / 2π.
```

7. A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, and a low-dielectric constant insulating layer is placed between the semiconductor substrate and a ground metal substrate such that the distance between the antennas and the ground metal substrate and the distance between the antennas and internal metal wires are greater than the far field distance determined depending on the wavelength of an electromagnetic wave propagated in a semiconductor:

```
distance = wavelength of wave propagated in Si

substrate / 2π.
```

8. A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished; a plurality of metal wiring layers are arranged perpendicularly to the radiation direction of the transmitting antenna, connected to each other with via-holes, and divided so as to have a length less than one eighth of the wavelength of an electromagnetic wave propagated in a semiconductor; and a power supply, a ground wire, and a common wire are arranged in parallel to the radiation direction of the transmitting antenna.

9. A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates are arranged so as to achieve multilayer integration, ground metal layers are each placed on the rear face of the semiconductor substrate and the rear face of the outermost semiconductor substrate located most far from the semiconductor substrate such that the ground metal layers cover the rear faces of the semiconductors and face outward, the other semiconductor substrates have no ground metal layers, and ground contact is achieved with a substrate surface.

10. A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, ground metal layers having a strip shape are arranged on the rear face of the semiconductor substrate and have a width less than one fourth of the wavelength of an electromagnetic wave propagated in a semiconductor, and the interval between the ground metal layers is greater than one fourth of the wavelength of such an electromagnetic wave propagated in a semiconductor.

11. A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, a lens-shaped insulating layer which is made of a material for forming a first or second interlayer insulating layer and which has a parabolic surface is placed above the transmitting antenna, the first and second interlayer insulating layers have different dielectric constants, and a metal layer is placed on the lens-shaped insulating layer.

**12.** A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, and timing is adjusted using delay times of a clock-receiving circuit when a synchronous clock signal radiated from the transmitting antenna is received with the receiving antennas, the delay times being obtained by dividing the distances from the transmitting antenna to each of the receiving antennas by the electromagnetic wave transmission speed.

**13.** A semiconductor device **characterized in that** an electromagnetic wave transmission signal is transmitted from a transmitting antenna placed on a semiconductor substrate to a receiving antenna placed on the semiconductor substrate or receiving antennas placed on a plurality of semiconductor substrates such that wireless interconnection is accomplished, the semiconductor substrates are arranged at equal intervals so as to achieve multilayer integration, a transmitting/receiving antenna placed on the semiconductor substrate is placed on the same side as that on which the transmitting antenna is placed and serves as a relay for a synchronous clock signal radiated from the transmitting antenna, and the maximum time obtained by dividing the distances between the transmitting and receiving antennas by the electromagnetic wave transmission speed is less than one fourth of the clock period.

**14.** A semiconductor device **characterized in that** an electromagnetic wave transmission signal is transmitted from a transmitting antenna placed on a semiconductor substrate to receiving antennas placed on a plurality of semiconductor substrates such that wireless interconnection is accomplished, the semiconductor substrates are arranged at equal intervals so as to achieve multilayer integration, and the transmitting and receiving antennas placed on the semiconductor substrates serve as broadband antennas that have a band with a transmission gain of -10 dB being greater than or equal to 25% of the center frequency.

# FIG. 1

（a）

（b）

# FIG. 2

（a）

（b）

## FIG. 3

```
                                                    ↑                    /10
                                          19: TRANSMISSION WAVE
                                  ┌──────────────────────────┐
                                  │      TRANSMISSION         │── 18
                                  │  WAVE-GENERATING CIRCUIT  │
                                  └──────────────────────────┘
                                              ↑
                                         17A: DELAY SIGNAL
    16: INPUT DATA SIGNAL          ┌──────────────────────────┐
    ──────────────────────────────▶│      INPUT SEQUENCE       │── 17
                                  │      DELAY CIRCUIT        │
                                  └──────────────────────────┘
                                              ↑
                         /13                  15: SPREAD CODE SIGNAL
    ┌──────────────────────┐       ┌──────────────────────────┐
    │    SPREAD CODE-       │──────▶│   TIME-HOPPING CIRCUIT    │── 14
    │  GENERATING CIRCUIT   │       └──────────────────────────┘
    └──────────────────────┘                  ↑
                                         12: PULSE WAVE
                                  ┌──────────────────────────┐
                                  │   FRAME CLOCK CIRCUIT     │── 11
                                  └──────────────────────────┘
```

## FIG. 4

```
                                            ↓                        /20
                                      27: RECEIVE SIGNAL
                              ↓
                          ┌──────────────────┐
          26: TRANSMISSION WAVE  │  PULSE CORRELATOR │── 28
   ┌──────────────────┐   └──────────────────┘
   │ TRANSMISSION WAVE-│── 25           ↓
   │ GENERATING CIRCUIT│        ┌──────────────────┐
   └──────────────────┘        │   PULSE TRAIN     │── 29
          ↑                     │ TOTALIZER CIRCUIT │
     24: SPREAD CODE SIGNAL     └──────────────────┘
   ┌──────────────────┐                 ↓
   │ TIME-HOPPING CIRCUIT│── 23  ┌──────────────────┐
   └──────────────────┘         │DISCRIMINATOR CIRCUIT│── 30
          ↑                      └──────────────────┘
     22: PULSE WAVE                      ↓
   ┌──────────────────┐          31: OUTPUT SIGNAL
   │ FRAME CLOCK CIRCUIT│── 21
   └──────────────────┘
```

# FIG. 5

# FIG. 6

(a)

143
142
141

(b)

144

143
142
141

(c)

145
143
142
141

(d)

146
145
143
142
141

# FIG. 7

(a)

147
146
145
143
142
141

(b)

148
143
142
141

(c)

148
149
143
142
141

(d)

150 151
148
149
143
142
141

# FIG. 8

(a)

(b)

(c)

# FIG. 9

(a)

(b)

THICKNESS (t) OF LOWER LAYERS OF ANTENNAS

# FIG. 10

LENGTH OF THE METAL WIRES (% of ANTENNA LENGTH)

- Simulated
- Measured

Antenna length=2 mm, distance=5 mm

Metal length

LENGTH OF THE METAL WIRES (mm)

# FIG. 11

(a)

(b)

FIG. 12

# FIG. 13

# FIG. 14

## FIG. 15

## FIG. 16

## INTERNATIONAL SEARCH REPORT

| International application No. |
|---|
| PCT/JP2004/004419 |

A. CLASSIFICATION OF SUBJECT MATTER
    Int.Cl$^7$  H01L27/04, H01L21/3205, H01Q1/38, H01Q1/40

According to International Patent Classification (IPC) or to both national classification and IPC

B. FIELDS SEARCHED

Minimum documentation searched (classification system followed by classification symbols)
    Int.Cl$^7$  H01L27/04, H01L21/3205, H01Q1/38, H01Q1/40

Documentation searched other than minimum documentation to the extent that such documents are included in the fields searched
    Jitsuyo Shinan Koho          1922–1996    Jitsuyo Shinan Toroku Koho    1996–2004
    Kokai Jitsuyo Shinan Koho    1971–2004    Toroku Jitsuyo Shinan Koho    1994–2004

Electronic data base consulted during the international search (name of data base and, where practicable, search terms used)
    IEL Online

C. DOCUMENTS CONSIDERED TO BE RELEVANT

| Category* | Citation of document, with indication, where appropriate, of the relevant passages | Relevant to claim No. |
|---|---|---|
| X<br>Y<br>A | A.B.M. Harun-ur Rashid et al., 'Interference Suppression of Wireless Interconnection in Si Integrated Anthenna', Proceedings of the IEEE 2002 International interconnect Technology Conference, 2002, pages 173 to 175 | 1<br>2,3<br>6-8,11-14 |
| X<br>Y<br>A | Brian A. Floyd et al., 'Intra-Chip Wireless Interconnect for Clock Distribution Implemented With Integrated Antennas, Receivers, and Trans mitters', IEEE Journal of Solid-State Circuits, Vol.37, No.5, May 2002, pages 543 to 552 | 1<br>2,3<br>6-8,11-14 |
| X<br>A | Xiaolin Guo et al., 'Propagation Layers for Intra-Chip Wireless Interconnection Compatible with Packaging and Heat Removal', 2002 Symposium On VLSI Technology Digest of Technical Papers, 2002, pages 36 to 37 | 1,6,7<br>2,3,8,11-14 |

| ☒  Further documents are listed in the continuation of Box C. | ☐  See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    19 May, 2004 (19.05.04) | Date of mailing of the international search report<br>    01 June, 2004 (01.06.04) |
|---|---|
| Name and mailing address of the ISA/<br>    Japanese Patent Office | Authorized officer |
| Facsimile No. | Telephone No. |

Form PCT/ISA/210 (second sheet) (January 2004)

**INTERNATIONAL SEARCH REPORT**

| International application No. |
| --- |
| PCT/JP2004/004419 |

C (Continuation). DOCUMENTS CONSIDERED TO BE RELEVANT

| Category* | Citation of document, with indication, where appropriate, of the relevant passages | Relevant to claim No. |
| --- | --- | --- |
| X<br>A | JP 2001-326328 A (New Japan Radio Co., Ltd.),<br>22 November, 2001 (22.11.01),<br>Full text; Figs. 1 to 13<br>(Family: none) | 1,12<br>2,3,6-8,11,<br>13,14 |
| X<br>A | JP 2000-124406 A (Kabushiki Kaisha Shinseshisu),<br>28 April, 2000 (28.04.00),<br>Full text; Figs. 1 to 6<br>(Family: none) | 1,14<br>2,3,6-8,<br>11-13 |

Form PCT/ISA/210 (continuation of second sheet) (January 2004)

# EP 1 617 475 A1

<table>
<tr><td>**INTERNATIONAL SEARCH REPORT**</td><td>International application No.<br>PCT/JP2004/004419</td></tr>
</table>

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☒ Claims Nos.: 4, 5, 9, 10
   because they relate to parts of the international application that do not comply with the prescribed requirements to such an extent that no meaningful international search can be carried out, specifically:
   As is described in the extra sheet, the inventions of claims 4, 5, 9, 10 are not sufficiently disclosed or supported by the Description and it is difficult to perform useful International Search for them.
   (Continued to extra sheet)

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**    ☐ The additional search fees were accompanied by the applicant's protest.

☐ No protest accompanied the payment of additional search fees.

Form PCT/ISA/210 (continuation of first sheet (2)) (January 2004)

28

**INTERNATIONAL SEARCH REPORT**

International application No.

PCT/JP2004/004419

<u>Continuation of Box No.II-2 of continuation of first sheet(2)</u>

The inventions of claims 4, 5, 9, 10 are not sufficiently disclosed or supported by the Description.

[About Claims 4, 5]
In the paragraph of the Best mode for carrying out the invention, it is explained that the third embodiment corresponds to claim 4. However, in the third embodiment, although it is described that the Si substrate should have a film thickness equal to or above the Far-Field boundary, there is disclosed no specific structure or experiment example for forming a photonic band-gap in the antenna transmission electromagnetic wave frequency. Moreover, in the other embodiments, no description is given on the specific structure of experiment example for forming the photonic band-gap in the antenna transmission electromagnetic wave frequency.

[About claim 9]
In the paragraph of the Best mode for carrying out the invention, it is explained that the fourth embodiment corresponds to claim 9 . However, in the fourth embodiment, it is described that when there is provided a metal wiring arranged vertical to the electromagnetic wave radiation direction of the antenna, the metal wiring has a length equal to or shorter than 1/8 of wavelength of the electromagnetic wave propagating in the Si substrate. However, no explanation is given on a specific structure or experiment example in which a plurality of semiconductor substrates are layered/integrated and a metal grounding layer is formed on the rear surface of the outermost semiconductor substrate farthest from the aforementioned semiconductor substrate and arranged to face outside, or on a specific structure or experiment example in which a grounding contact is arranged from the substrate surface without forming the rear surface grounding metal layer on a semiconductor substrate and on the semiconductor substrate other than the outermost semiconductor substrate farthest from the aforementioned semiconductor substrate. Furthermore, in the other embodiments, no explanation is given on a specific structure or experiment example in which a metal grounding layer is formed on the rear surface of the outermost semiconductor substrate farthest from the aforementioned semiconductor substrate and arranged to face outside, or on a specific structure or experiment example in which a grounding contact is arranged from the substrate surface without forming the rear surface grounding metal layer on a semiconductor substrate and on the semiconductor substrate other than the outermost semiconductor substrate farthest from the aforementioned semiconductor substrate.

[About claim 10]
None of the embodiments as the best modes for carrying out the invention describes a specific structure or an experiment example in which the grounding metal layer of the semiconductor substrate rear surface is divided into stripes having has a width smaller than 1/4 of the wavelength of the electromagnetic wave in the semiconductor and an interval greater than 1/4 of the wavelength of the electromagnetic wave in the semiconductor.

Form PCT/ISA/210 (extra sheet) (January 2004)